# EUROPEAN PATENT APPLICATION

(11) **EP 1 047 104 A1**
(43) Date of publication of application: **25.10.2000**
(21) Application number: 99107756.1
(22) Date of filing: 19.04.1999
(51) Int. Cl.: H01J 37/305, H01J 37/317

(54) **Apparatus for particle beam induced modification of a specimen**

(71) Applicant: ADVANTEST CORPORATION, Shinjuku-ku, Tokyo 163-08 (JP)
(72) Inventor: Frosien, Jürgen Dr., 85521 Riemerling (DE)
(74) Representative: Tetzner, Michael, Dipl.-Ing.

(57) **Abstract**

The invention relates to an apparatus for particle beam induced modification of a specimen, comprising a source for generating a particicle beam and a component (3,4) having means (3a,3b) for supplying a gas in the region of the specimen. The said component also has electrodes (4a,4b,...) which can be supplied with a variable voltage.

## Description

The invention relates to an apparatus for a particle beam induced modification of a specimen, comprising a source for generating a particle beam and a component having means for supplying a gas in the region of the specimen.

Particle beam induced processes are well known for precise modification approaches especially in the semiconductor industry. Here, device modification is performed on a micrometre and nanometre scale for chip and mask repair and fast chip prototyping. Two basic modification techniques are applied for local processing with high spatial resolution: material etching and material deposition.

Those techniques are mainly applied in focussed ion beam systems. However equivalent techniques are also known from electron beam systems (D. Winkler et al, "E-beam probe station with integrated tool for electron beam induced etching", Microelectronic Engineering 31 (1996) 141 to 147).

In such a particle beam apparatus a particle beam is generated and focussed onto a specimen to be modified. A deflection system in the particle beam system deflects the beam to or scans the beam in those areas in which the modification is to take place. Additionally, a gas is supplied in the modification area of the specimen by means of a gas nozzle, which creates a gas atmosphere in the beam interaction area of the specimen. Due to the interaction of the particle beam with the gas molecules, chemically active atoms and radicals will be generated, which can interact with the specimen in the area of the beam interaction. Basically, two processes can be performed depending on the gases supplied. The following table shows some examples of materials and corresponding modification gases:

| **Material to be deposited** | **Applied gas** |
|---|---|
| Gold, Au | Dimethyl-gold-trifluoroacetylacetonate |
| Platinum, Pt | Trimethyl platinum |
| Tungsten, W | Tungsten hexacarbonyl |
| Silicon oxide | Tetramethoxysilane |
| Copper | Hexafluoro-acetyo-acetonate copper vinyl-trimethysilane |
| | |
| **Material to be etched** | **Etching gas** |
| Silicon oxide, Silicon | Xenon-difluoride |
| Aluminium | Chlorine |
| Resist | Water |

The gas supply unit has to be placed after the final objective lens very close to the specimen in order to achieve a high-density gas atmosphere for a fast modification process. This placement of the gas supply unit next to the particle beam, however, can cause limitations regarding the beam performance. Especially in high end systems, in which high spatial resolution (fine probe size) is generated by electrical fields, the nozzle generates interferences. Since the nozzle is made of conductive material (in order to avoid charging), it distorts the electrical field and will consequently increase the probe diameter of the particle beam. This will reduce system resolution and, correspondingly, will increase the minimum feature size applicable for modification.

The object of the invention, therefore, is to improve the apparatus for particle beam induced modification so that it allows particle beam modification without the restriction of resolution loss due to the presence of the gas supply means.

The object is achieved by the features of claim 1 in that the component having means for supplying a gas in the region of the specimen also has electrodes which can be supplied with a variable voltage.

Further embodiments of the invention are the subject matter of the subordinate claims.

In one embodiment the means for supplying a gas comprise nozzles which form the electrodes. In another embodiment, the nozzles are integrated in the electrodes.

By arranging the electrodes in a multipole configuration it is possible to use these electrodes as a deflector and/or stigmator. Furthermore, it is possible to generate an axial acceleration or deceleration field.

Further embodiments and advantages of the invention are explained in greater detail below with reference to the drawings, in which:
- Fig.1: shows a schematic representation of the apparatus according to a first embodiment,
- Figs.2 to 4: show schematic top views of different examples of the gas supply means and the electrodes according to the first embodiment,
- Fig.5: shows a schematic representation of the apparatus according to a second embodiment,
- Fig.6: shows a schematic top view of the gas supply means and the electrodes according to the second embodiment and
- Fig.7: shows a sectional view along the line VI-VI of Fig.6.

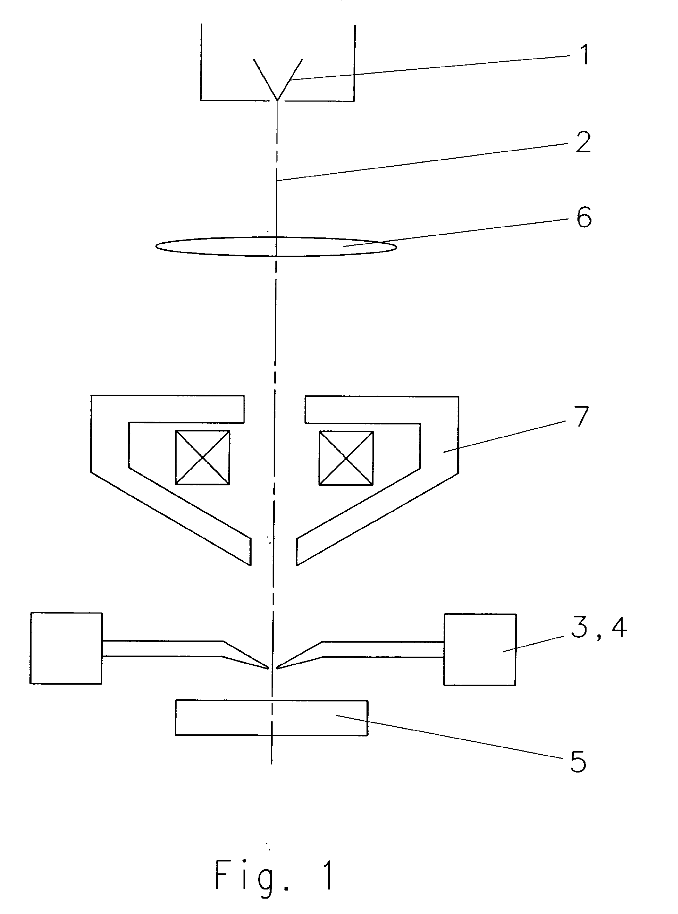

Fig.1 shows an apparatus for particle beam induced modification of a specimen comprising a source 1 for generating a particle beam 2 and a component having means 3 for supplying a gas in the region of a specimen 5 and electrodes 4 which can be supplied with a variable voltage.

Furthermore, the apparatus comprises a lens system 6 and an objective lens 7. Of course, the apparatus consists of further means which are not illustrated, such as, for instance, a deflector and a detector.

The means 3 for supplying a gas in the region of the specimen comprise nozzles which also form the electrodes.

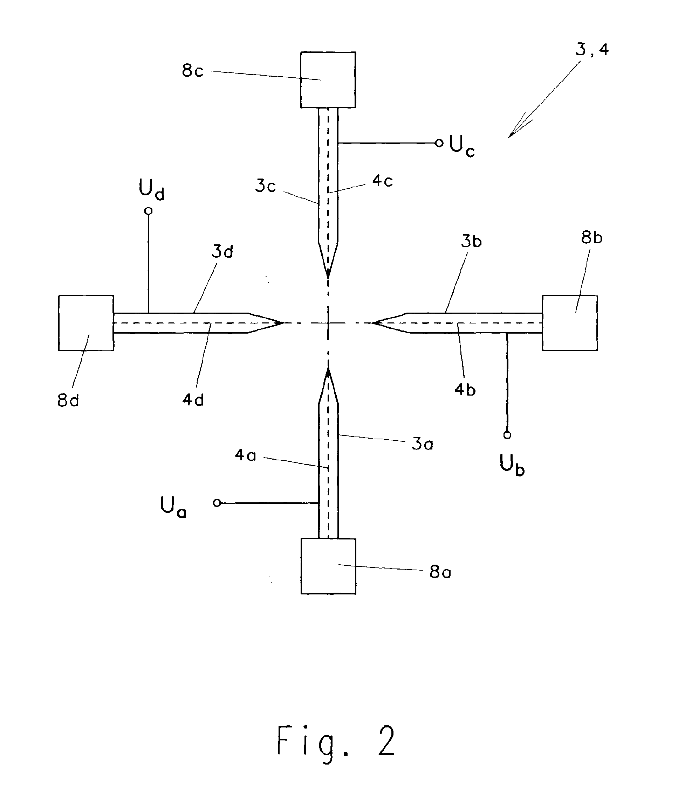

Figs.2 to 4 show some examples of this component. The electrodes are preferably arranged in a multipole configuration.

Fig.2 discloses a quadrupole configuration of the electrodes 4a, 4b, 4c, 4d which are formed by nozzles 3a, 3b, 3c, 3d. Each nozzle is connected to a separate or common gas reservoir 8a, 8b, 8c, 8d.

As the nozzles are made of conductive material, they can easily form the electrodes which can be supplied with variable voltages Uₐ, U_{b}, U_{c}, U_{d}.

By applying symetric voltages to the electrodes 4a, 4b, 4c, 4d, i.e. Uₐ = - U_{c} and U_{b} = - U_{d}, it is possible to use this configuration to deflect the particle beam 2.

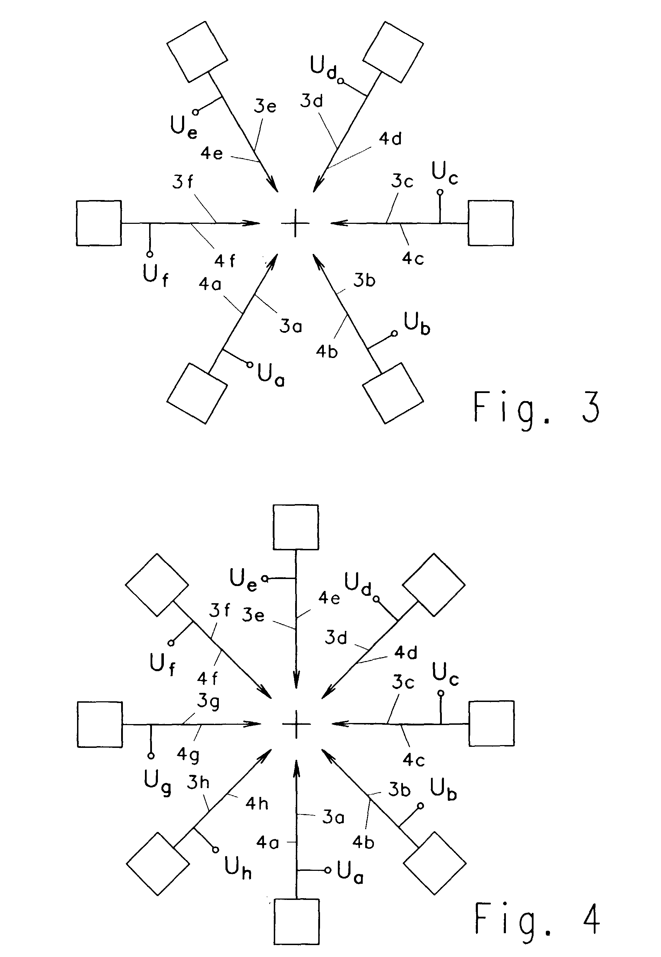

Fig.3 discloses a hexapole configuration with nozzles 3a, 3b, 3c, 3d, 3e and 3f, forming electrodes 4a, 4b, 4c, 4d, 4e and 4f. By applying suitable voltages, it is possible to use this hexapole configuration for beam deflection and/or beam stigmatism.

The octupole configuration according to Fig.4 allows the deflection of the particle beam in two directions by applying suitable voltages to four electrodes, e.g. 4a, 4c, 4e and 4g. Additonally, this configuration can be used as a stigmator for the particle beam.

Of course, other multipole configurations are also possible. In addition to the already mentioned multipole voltages, common (positive or negative) voltages can be applied to all electrodes in order to generate an axial acceleration or deceleration field for the particle beam. This additional axial field can also be used for the design of an effective detection system for the secondary particles generated by the particle beam.

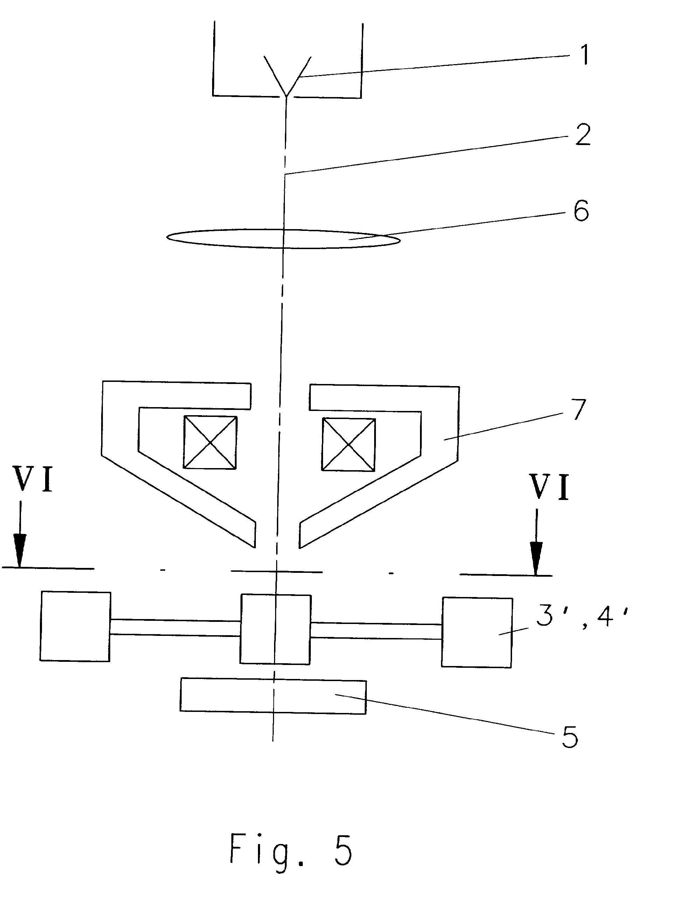

Fig.5 discloses an apparatus for particle beam induced modification of a specimen according to a second embodiment. It differs merely in the component having means 3' for supplying a gas and having electrodes 4' which can be supplied with a variable voltage.

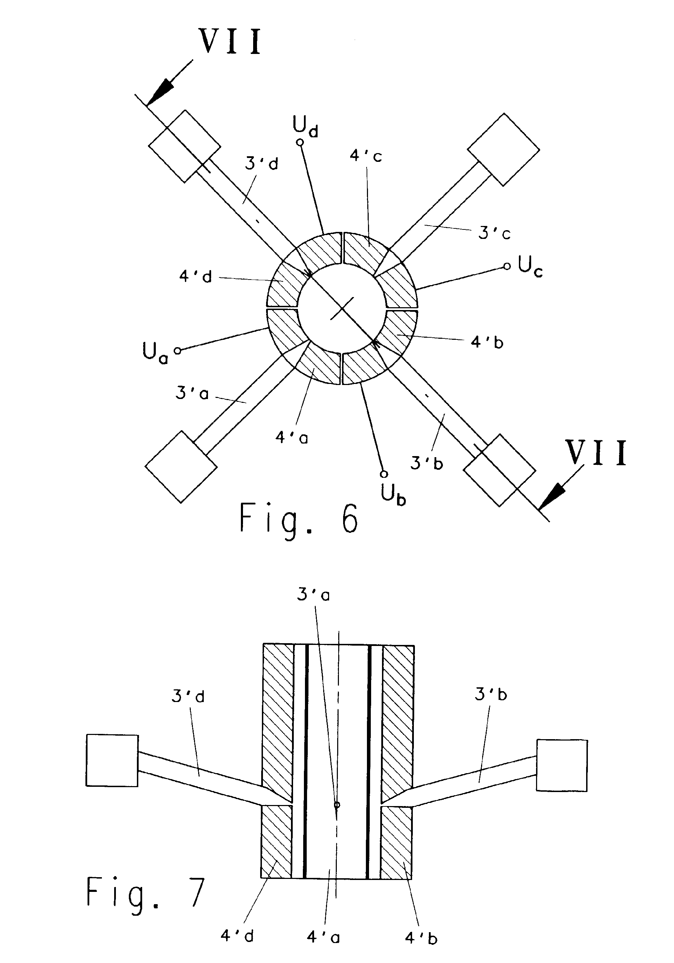

Figs.6 and 7 disclose this component in greater detail. The electrodes of the second embodiment are not formed by the nozzles themselves. On the contrary, the nozzles are integrated in the electrodes. The electrodes are formed, e.g., by separate plates or parts of a tube as disclosed in Figs.6 and 7. Every electrode has integrated a nozzle which leads into the tube formed by all electrodes. By using all nozzles for supplying the same gas in the region of the specimen, it is possible to create a homogeneous gas atmosphere which results in a more uniform material etching or material deposition.

In Figs.6 and 7 the electrodes are arranged in a quadrupole configuration. However, other multipole configurations are also possible.

According to the invention it is not at all necessary that every electrode is provided with a nozzle.

As described with respect to the first embodiment, the electrode of the second embodiment may achieve additional functions or take over functions which are performed by other optical components. Accordingly, the electrodes can be used as a deflector for the particle beam or as a stigmator or both. Furthermore, they may be adapted to generate an axial acceleration or deceleration field.

All embodiments have in common that the component comprising the means 3, 3' for supplying a gas and the electrodes 4, 4' is placed between the objective lens 7 and the specimen 5. Preferably, it should be placed close to the specimen and should have its axis on the optical axis of the particle beam apparatus. By arranging the nozzles together with the electrodes in a multipole configuration a symmetry of the means 3, 3' for supplying the gas is created which decreases asymmetrical distortions of the particle beam. By arranging the electrodes in combination with the nozzles, it is possible to achieve additional functions or to take over functions which are performed by other optical components. This, in most cases, will reduce the working distance of the objective lens which additionally will improve the optical system performance.

## Claims

1. Apparatus for particle beam induced modification of a specimen, comprising
- a source (1) for generating a particle beam (2)
- and a component (3, 4; 3', 4') having means (3a, 3b...; 3'a, 3'b...) for supplying a gas in the region of the specimen (5),
characterised in that
the said component also has electrodes (4a, 4b...; 4'a. 4'b...) which can be supplied with a variable voltage.

2. Apparatus according to claim 1, characterised in that the means for supplying a gas comprise nozzles (3a, 3b...) which form the electrodes (4a, 4b...).

3. Apparatus according to claim 1, characterised in that the means for supplying a gas comprise nozzles (3'a, 3'b...) which are integrated in the electrodes (4'a, 4'b...).

4. Apparatus according to one of the preceding claims, characterised in that the electrodes (4a, 4b...; 4'a, 4'b...) are arranged in a multipole configuration.

5. Apparatus according to claim 4, characterised in that the multipole configuration is used as a deflector for the particle beam.

6. Apparatus according to claim 4, characterised in that the multipole configuration is used as a stigmator for the particle beam.

7. Apparatus according to claim 4, characterised in that the multipole configuration is used as a deflector and a stigmator for the particle beam.

8. Apparatus according to one of claims 1 to 4, characterised in that the electrodes (4a, 4b...; 4'a, 4'b...) are arranged and adapted to generate an axial acceleration or deceleration field.

9. Apparatus according to one of the preceding claims, characterised in that the electrodes are arranged in a quadrupole configuration.

10. Apparatus according to one of claims 1 to 8, characterised in that the electrodes are arranged in a hexapole configuration.

11. Apparatus according to one of claims 1 to 8, characterised in that the electrodes are arranged in an octupole configuration.
